# EUROPÄISCHE PATENTSCHRIFT

(11) **EP 0 732 804 B1**
(45) Veröffentlichungstag und Bekanntmachung des Hinweises auf die Patenterteilung: **06.02.2002**
(21) Anmeldenummer: 96103738.9
(22) Anmeldetag: 09.03.1996
(51) Int. Cl.: H03H 7/01

(54) **Filterschaltung**
Filter circuit
Circuit de filtrage

(30) Priorität: 17.03.1995 DE 19509644
(43) Veröffentlichungstag der Anmeldung: 18.09.1996
(73) Patentinhaber: DEUTSCHE THOMSON-BRANDT GMBH, 78048 Villingen-Schwenningen (DE)
(72) Erfinder: Düllberg, Gerald, 58636 Iserlohn (DE); Armbruster, Veit, 78112 St. Georgen (DE); Peusens, Herbert, 78086 Brigachtal (DE)
(74) Vertreter: Rossmanith, Manfred, Dr.

(56) Entgegenhaltungen:
- DE-A- 2 206 460
- FR-A- 2 104 616
- US-A- 2 174 963
- PATENT ABSTRACTS OF JAPAN vol. 6, no. 160 (E-126), 21.August 1982 & JP-A-57 080809 (HITACHI LTD), 20.Mai 1982,

## Beschreibung

Die Erfindung betrifft eine Filterschaltung nach dem Oberbegriff des Anspruchs 1.

Bei der Überlagerung eines Hochfrequenzsignals mit einem Oszillatorsignal in einer Mischstufe treten zwei Mischprodukte auf, nämlich die Summe und die Differenz der Frequenzen der Signale. Wenn man eine dieser Frequenzen einem Nutzsignal zuordnet, wird die andere Frequenz als Spiegelfrequenz bezeichnet.

Liegen die Nutzfrequenz und die Spiegelfrequenz dicht beieinander, so werden an die Selektionsmittel eines nachfolgenden Verstärkers hohe Anforderungen gestellt, die ein einfaches zweikreisiges Bandpaßfilter allein nicht mehr erfüllen kann.

Bei Doppelumsetztunern für Fernsehanwendungen wird ein Fernsehsignal von seiner ursprünglichen Frequenz, im Bereich 50-850 MHz, auf eine 1. Zwischenfrequenz, die im Frequenzbereich um 1 GHz liegt, hochgemischt und anschließend mit einem 2. Mischer auf eine 2. Zwischenfrequenz von ca. 40 MHz heruntergemischt.

Für das 1. ZF-Signal besteht nun die Problematik, daß beim Heruntermischen mit einem Oszillatorsignal, dessen Frequenz ca. 40 MHz unterhalb der 1. Zwischenfrequenz liegt, zugleich eine Frequenz, die ca. 40 MHz unterhalb der Oszillatorfrequenz und damit ca. 80 MHz unter der 1. Zwischenfrequenz liegt, in die 2. Zwischenfrequenz heruntergemischt wird (Spiegelfrequenz). Diese Frequenz gilt es in der 1. Zwischenfrequenz wirksam zu unterdrücken.

Zur Trennung eines Nutzsignals von einem benachbarten Störsignal ist es bereits bekannt, einen Saugkreis mit einem Sperrkreis zu kombinieren. Dabei wird der eine Kreis auf die Frequenz des Nutzsignals und der andere Kreis auf die Frequenz des Störsignals abgestimmt und die Kreise werden so angeordnet, daß der auf die Störfrequenz abgestimmte Kreis diese dämpft, während der auf die Nutzfrequenz abgestimmte Kreis diese anhebt. Bei konventionellem Aufbau für jeden Kreis aus Induktivität und Kapazität werden insgesamt vier Bauelemente benötigt.

Der Erfindung liegt die Aufgabe zugrunde, eine Filterschaltung zu schaffen, die bei gleichen Selektionseigenschaften einen geringeren Bauteileaufwand als ein konventioneller Schaltungsaufbau benötigt.

Diese Aufgabe wird bei einer Filterschaltung nach dem Oberbegriff des Anspruchs 1 durch die Kennzeichen angegebenen Merkmale gelöst.

Durch die erfindungsgemäße Lösung wird nicht nur der Bauteileaufwand verringert, es ist außerdem möglich auf einen Abgleich zu verzichten. Besonders bei Schaltungen für Geräte des Konsumsektors, die in großen Stückzahlen hergestellt werden, sind diese beiden Kriterien von erheblicher Bedeutung für die Produktionskosten.

Bei einer Ausbildung der erfindungsgemäßen Filterschaltung für Frequenzen des UHF-Bereichs und höher ist vorgesehen, daß der Sperrkreis durch einen λ/4 Koaxstub gebildet ist.

Dies ist auch im Dokument DE-A-2 206 460 der Fall, in dem jedoch der entstehende Parallelschwingkreis nicht auf die Nutzfrequenz abgestimmt ist.

Gegenüber Kreisen mit konventionellen Bauteilen aus einer diskreten Kapazität und einer diskreten Induktivität bietet diese Lösung nochmals eine Verringerung des Bauteileaufwands und zudem den Vorteil geringerer Toleranz, da bei entsprechender elektrischer Anordnung in der Schaltung die Resonanzfrequenz eines Koaxstubs nicht durch benachbarte elektronische oder mechanische Bauteile beeinflußt wird. Daher ist es möglich, den Koaxstub schon bei der Herstellung für die Resonanzfrequenz zu bemessen, so daß ein gesonderter Abgleich entfallen kann.

Vorzugsweise ist der λ/4 Koaxstub parallel zum Eingang der Verstärkerstufe geschaltet und an seinem auf Bezugspotential liegenden kalten Ende kurzgeschlossen, wobei λ die der Zwischenfrequenz entsprechende Wellenlänge ist.

Da bei dieser Lösung der Mantel des λ/4 Koaxstubs auf Bezugspotential liegt, wird die Resonanzfrequenz ausschließlich durch die mechanischen Abmessungen von Seele und Mantel sowie dem Dielektrikum des Koaxstubs bestimmt.

Der Saugkreis kann in diesem Fall durch eine Serienschaltung aus einer Kapazität und dem λ/4 Koaxstub gebildet sein. Die Kapazität liegt zwischen dem Eingang der Verstärkerstufe und dem heißen Ende des λ/4 Koaxstubs.

Diese Schaltung ist dann geeignet, wenn die zu dämpfende Stör- oder Spiegelfrequenz niedriger als die Nutzfrequenz liegt. In diesem Fall wirkt die Kapazität bei der Nutzfrequenz lediglich als Koppelkapazität des λ/4 Koaxstubs, während bei der Stör- oder Spiegelfrequenz die Serienresonanz durch den Wert der diskreten Kapazität und den Wert der effektiven Induktivität des Koaxstubs gebildet ist. Auch die Resonanzfrequenz dieses Kreises wird nicht durch die Umgebung beeinflußt. Somit kann durch Einsatz einer engtolerierten Kapazität gänzlich auf einen Abgleich verzichtet werden.

Durch Verwendung eines keramischen Materials als Dielektrikum besteht die Möglichkeit, den λ/4 Koaxstub mit geringer Baugröße, geringem Temperaturgang und hoher Güte zu realisieren. Bei einer praktischen Ausführung beträgt die relative Dielektrizitätskonstante εᵣ des keramischen Materials etwa 88 und die Güte 200.

Vorzugsweise beträgt der Wellenwiderstand Z₀ des λ/4 Koaxstubs etwa 3,5 Ohm. Dadurch ergibt sich in Verbindung mit höheren Eingangsimpedanzen der nachfolgenden Verstärkerstufe eine bessere Selektion.

Die erfindungsgemäße Filterschaltung ist besonders vorteilhaft einsetzbar bei Mehrfachumsetzern für Kabel- oder Satellitenempfang im Bereich von ca. 1 bis 2 GHz, bei der die Nutzfrequenz und die Spiegel- oder Störfrequenz um ca. 78 MHz auseinander liegen.

Vorzugsweise beträgt die Eingangs- und Ausgangsimpedanzen der Verstärkerstufe etwa 50 Ohm.

Zur Selektion der Zwischenfrequenz dient ein Bandpaßfilter, das ein auf die Resonanzfrequenz des Sperrkreises als Mittenfrequenz abgestimmtes Zwei-Kreis-Keramikfilter umfaßt.

Eine Weiterbildung der Erfindung sieht vor, daß das vorgeschaltete Filter aus mehreren kaskadierten Fallen besteht. Hierduch kann die Dämpfung der Stör- oder Spiegelfrequenz weiter erhöht werden.

Bei einer praktischen Ausgestaltung sind die Fallen durch passive Kopplungsglieder gekoppelt, wobei die passiven Kopplungsglieder als T-Dämpfungsglieder und/oder als π-Dämpfungsglieder ausgebildet sein können.

Während eine einfache Parallelschaltung zweier gleichartiger Fallen lediglich eine zusätzliche Dämpfung von 6 dB bewirken würde, gelingt es durch die Zwischenschaltung von Kopplungsgliedern, die Dämpfungswerte der einzelnen Fallen nahezu zu summieren. Im Gegensatz zu sonst üblichen Trennverstärkern als Kopplungsgliedern vermeidet diese Lösung zusätzliche nichtlineare Verzerrungen, wie sie bei sie bei Trennverstärkern immer entstehen würden. Außerdem sind passive Kopplungsglieder wesentlich kostengünstiger und damit für Geräte des Konsumsektors besonders geeignet. Die geringe zusätzliche Dämpfung der Kopplungsglieder kann ohne weiteres hingenommen werden, da sie sich durch entsprechende Bemessung der ohnehin vorhandenen Verstärkerstufe leicht ausgleichen läßt.

Eine ausreichede Entkopplung der Fallen bei gleichzeitig geringer Einfügedämpfung wird erzielt, wenn die passiven Kopplungsglieder die gleiche Eingangs- und Ausgangsimpedanz wie die Verstärkerstufe und jeweils eine Dämpfung von 3 dB aufweisen.

Nachfolgend wird die Erfindung anhand von Ausführungsbeispielen erläutert, die in der Zeichnung dargestellt sind.

In der Zeichnung zeigen:
- Fig. 1: eine Schaltung einer Filterschaltung nach der Erfindung,
- Fig. 2: eine Übertragungsfunktion eines Bandpaßfilters der Filterschaltung,
- Fig. 3: eine Übertragungsfunktion der gesamten Filterschaltung gemäß Fig. 1 und
- Fig. 4: ein vorgeschaltetes Filter mit drei kaskadierten Fallen.

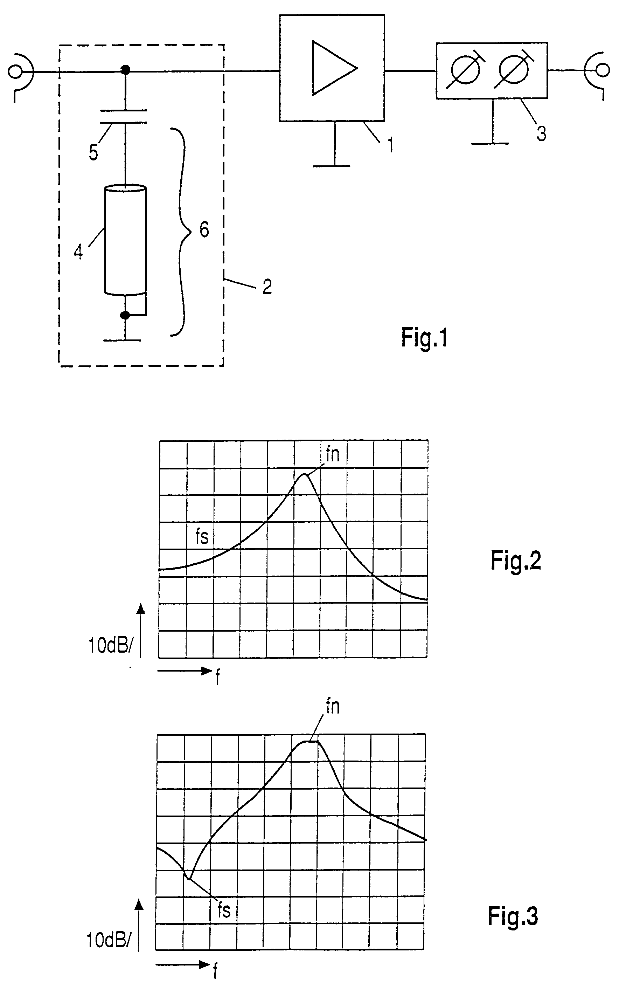

Die in Fig. 1 dargestellte Schaltung umfaßt eine Verstärkerstufe 1, ein der Verstärkerstufe 1 vorgeschaltetes Filter 2 aus der Kombination eines Sperrkreises mit einem Saugkreis und ein der Verstärkerstufe 1 nachgeschaltetes zweikreisiges Bandpaßfilter 3. Der Sperrkreis des Filters ist durch einen auf die Nutzfrequenz £n abgestimmten, an seinem kalten, auf Bezugspotential liegenden Ende kurzgeschlossenen λ/4 Koaxstub 4 gebildet. Der λ/4 Koaxstub 4 besitzt ein Dielektrikum aus keramischem Material mit einer relativen Dielektrizitätskonstante εᵣ von etwa 88. Sein Wellenwiderstand Z₀ beträgt 3,5 Ohm. Die elektrische Länge beträgt: lₑₗ = lₚₕ*√εᵣ. Zwischen dem heißen Ende des λ/4 Koaxstubs 4 und einem Eingang der Verstärkerstufe 1 ist eine Kapazität 5 angeordnet. Diese Kapazität 5 ist so bemessen, daß sie mit dem für die Spiegelfrequenz fₛ als Induktivität wirkenden λ/4 Koaxstub 4 einen auf die Spiegelfrequenz abgestimmten Saugkreis bildet. Die Induktivität des λ/4 Koaxstubs 4 errechnet sich nach L = Z/ω mit Z = Z_{0^{*}}tan(1/λ*2π), wobei ω die Kreisfrequenz ω = 2π*f, Z₀ der Wellenwiderstand des Koaxstubs 4, 1 die elektrische Länge des Leitungsstücks und λ = c/f die Wellenlänge der Frequenz ist. Die erforderliche Kapazität zur Bildung des Saugkreises ist dann C = 1/ω²L.
Die Verstärkerstufe 1 dient zur Entkopplung des Filters 2 aus dem kombinierten Sperrkreis und Saugkreis vom Bandpaßfilter 3. Sie weist eine Eingangs- und Ausgangsimpedanz von jeweils 50 Ohm auf. Als Verstärkerstufe 1 sind sowohl integrierte Schaltkreise geeignet, die von ihren Spezifikationen her bereits diese Eingangs- und Ausgangsimpedanz aufweisen, oder auch konventionelle Transistorverstärkerstufen mit jeweils einem vor- und nachgeschalteten Anpassungsnetzwerk.

Das der Verstärkerstufe 1 nachgeschaltete Bandpaßfilter 3 ist ein auf die Resonanzfrequenz des Sperrkreises als Mittenfrequenz abgestimmtes Zwei-Kreis-Keramikfilter.

Fig. 2 zeigt eine Übertragungsfunktion eines Bandpaßfilters 3 der Filterschaltung. In diesem Diagramm ist die Lage der Nutzfrequenz von 959 MHz mit fₙ und die Lage der Spiegelfrequenz von 881 MHz mit fₛ bezeichnet. Die Spiegelfrequenz ist hierbei gegenüber der Nutzfrequenz um mehr als 28 dB gedämpft.

Fig. 3 zeigt eine Übertragungsfunktion der gesamten Filterschaltung nach Fig. 1. Auch in diesen Diagramm ist die Lage der Nutzfrequenz mit fₙ und die Lage der Spiegelfrequenz mit fₛ bezeichnet. Während der Durchlaßbereich praktisch nicht beeinflußt ist, ist die Spiegelfrequenz fₛ gegenüber der Nutzfrequenz fₙ um fast 60 dB gedämpft.

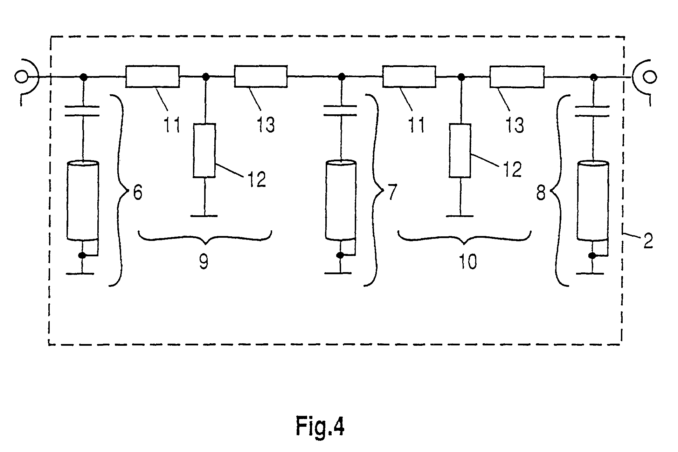

Reicht die mit der Filterschaltung nach Fig. 1 erzielte Dämpfung noch nicht aus, so kann das vorgeschaltete Filter 2 statt mit einer einzigen Falle 6 mit einer oder mehreren weiteren kaskadierten Fallen 6, 7, 8 aufgebaut werden, wie es Fig. 4 veranschaulicht. Die Fallen 6, 7, 8 sind jeweils identisch aufgebaut und durch passive Kopplungsglieder 9 und 10 gekoppelt, die als T-Dämpfungsglieder mit Widerständen 11, 12, 13 ausgebildet sind.

Die Kopplungsglieder 9 und 10 weisen jeweils eine Eingangs- und Ausgangsimpedanz von 50 Ohm und eine Dämpfung von vorzugsweise 3 dB auf. Ausgehend von einer Störfrequenzdämpfung von 28 dB einer einzelnen Falle wurden für zwei über ein 3 dB Kopplungsglied gekoppelte Fallen zusätzlich 23 dB, also insgesamt 51 dB und für drei über zwei 3 dB Kopplungsglieder gekoppelte Fallen insgesamt 73 dB ermittelt. Diese Dämpfungswerte sind relativ zum Nutzsignal angegeben, d. h. von der absoluten Dämpfung wurde bereits die Einfügedämpfung von 3 dB für ein Kopplungsglied bzw. 6 dB für zwei Kopplungsglieder abgezogen.

## Patentansprüche

1. Filterschaltung, welche eine Verstärkerstufe (1), ein der Verstärkerstufe (1) vorgeschaltetes Filter (2) mit wenigstens einer Falle (6) aus einem auf eine Zwischenfrequenz abgestimmten Sperrkreis und einem auf eine Spiegelfrequenz abgestimmten Saugkreis sowie ein der Verstärkerstufe (1) nachgeschaltetes, auf die Zwischenfrequenz abgestimmtes Bandpassfilter (3) umfaßt, **dadurch gekennzeichnet, daß** der Sperrkreis und der Saugkreis eine gemeinsame Induktivität aufweisen.

2. Filterschaltung nach Anspruch 1, **dadurch gekennzeichnet, daß** einer der Kreise durch einen λ/4 Koaxstub (4) gebildet ist, wobei λ die der Zwischenfrequenz entsprechende Wellenlänge ist.

3. Filterschaltung nach Anspruch 2, **dadurch gekennzeichnet, daß** der λ/4 Koaxstub (4) parallel zum Eingang der Verstärkerstufe (1) geschaltet ist, an seinem auf Bezugspotential liegenden kalten Ende kurzgeschlossen ist.

4. Filterschaltung nach Anspruch 2 oder 3, **dadurch gekennzeichnet, daß** der Saugkreis durch eine Serienschaltung aus einer Kapazität (5) und dem λ/4 Koaxstub (4) gebildet ist.

5. Filterschaltung nach Anspruch 4, **dadurch gekennzeichnet, daß** die Kapazität (5) zwischen dem Eingang der Verstärkerstufe (1) und dem heißen Ende des λ/4 Koaxstubs (4) angeordnet ist.

6. Filterschaltung nach einem der Ansprüche 2 bis 5, **dadurch gekennzeichnet, daß** der λ/4 Koaxstub (4) ein Dielektrikum aus keramischem Material besitzt.

7. Filterschaltung nach Anspruch 6, **dadurch gekennzeichnet, daß** die relative Dielektrizitätskonstante εᵣ des keramischen Materials etwa 88 beträgt.

8. Filterschaltung nach einem der Ansprüche 2 bis 6, **dadurch gekennzeichnet, daß** der Wellenwiderstand Z₀ des λ/4 Koaxstubs (4) etwa 3,5 Ohm beträgt.

9. Filterschaltung nach einem der Ansprüche 1 bis 8, **dadurch gekennzeichnet, daß** die Resonanzfrequenzen des Sperrkreises und des Saugkreises im Bereich von 1 bis 2 GHz liegen, wobei die Resonanzfrequenz des Saugkreises um 78 MHz unterhalb derjenigen des Sperrkreises liegt.

10. Filterschaltung nach einem der Ansprüche 1 bis 9, **dadurch gekennzeichnet, daß** die Eingangs- und Ausgangsimpedanzen der Verstärkerstufe (4) etwa 50 Ohm betragen.

11. Filterschaltung nach Anspruch 6, **dadurch gekennzeichnet, daß** das Bandpaßfilter (3) ein auf die Resonanzfrequenz des Sperrkreises als Mittenfrequenz abgestimmtes Zwei-Kreis-Keramikfilter ist.

12. Filterschaltung nach einem der Ansprüche 1 bis 11, **dadurch gekennzeichnet, daß** das vorgeschaltete Filter (2) aus mehreren kaskadierten Fallen (6, 7, 8) besteht.

13. Filterschaltung nach Anspruch 12, **dadurch gekennzeichnet, daß** die Fallen (6, 7, 8) durch passive Kopplungsglieder (9, 10) gekoppelt sind.

14. Filterschaltung nach Anspruch 13, **dadurch gekennzeichnet, daß** die passiven Kopplungsglieder (9, 10) als T-Dämpfungsglieder und/oder π-Dämpfungsglieder ausgebildet sind.

15. Filterschaltung nach Anspruch 13 oder 14, **dadurch gekennzeichnet, daß** die passiven Kopplungsglieder (9) die gleiche Eingangs- und Ausgangsimpedanz wie die Verstärkerstufe (2) aufweisen.

16. Filterschaltung nach einem der Ansprüche 13 bis 15, **dadurch gekennzeichnet, daß** die passiven Kopplungsglieder (9) jeweils eine Dämpfung von 3 dB aufweisen.

## Claims

1. Filter circuit which comprises an amplifier stage (1), a filter (2) which is connected upstream of the amplifier stage (1) and has at least one trap (6) composed of a rejection circuit, which is tuned to an intermediate frequency, and a series-tuned circuit, which is tuned to an image frequency, as well as a bandpass filter (3) which is connected downstream of the amplifier stage (1), and which is tuned to the intermediate frequency,
**characterized in that**
the rejection circuit and the series-tuned circuit have a common inductance.

2. Filter circuit according to claim 1, **characterized in that** one of the circuits is formed by a λ/4 coaxial stub (4), wherein λ is the wavelength corresponding to the intermediate frequency.

3. Filter circuit according to claim 2, **characterized in that** the λ/4 coaxial stub (4) is connected in parallel with the input of the amplifier stage (1) and is shortcircuited at its earthed end, which is at reference-earth potential.

4. Filter circuit according to claim 2 or 3, **characterized in that** the series-tuned circuit is formed by a series circuit composed of a capacitor (5) and the λ/4 coaxial stub (4).

5. Filter circuit according to claim 4, **characterized in that** the capacitor (5) is arranged between the input of the amplifier stage (1) and the live end of the λ/4 coaxial stub (4).

6. Filter circuit according to one of claims 2 to 5, **characterized in that** the λ/4 coaxial stub (4) has a dielectric composed of ceramic material.

7. Filter circuit according to claim 6, **characterized in that** the relative dielectric constant εᵣ of the ceramic material is approximately 88.

8. Filter circuit according to one of claims 2 to 6, **characterized in that** the characteristic impedance Z₀ of the λ/4 coaxial stub (4) is approximately 3.5 ohms.

9. Filter circuit according to one of claims 1 to 8, **characterized in that** the resonant frequencies of the rejection circuit and of the series-tuned circuit are in the range from 1 to 2 GHz, the resonant frequency of the series-tuned circuit being 78 MHz below that of the rejection circuit.

10. Filter circuit according to one of claims 1 to 9, **characterized in that** the input and output impedances of the amplifier stage (4) are approximately 50 ohms.

11. Filter circuit according to claim 6, **characterized in that** the bandpass filter (3) is a two-circuit ceramic filter tuned to the resonant frequency of the rejection circuit as the mid-frequency.

12. Filter circuit according to one of claims 1 to 11, **characterized in that** the upstream filter (2) comprises a plurality of cascaded traps (6, 7, 8).

13. Filter circuit according to claim 12, **characterized in that** the traps (6, 7, 8) are coupled by means of passive coupling elements (9, 10).

14. Filter circuit according to claim 13, **characterized in that** the passive coupling elements (9, 10) are designed as T-attenuators and/or π-attenuators.

15. Filter circuit according to claim 13 or 14, **characterized in that** the passive coupling elements (9) have the same input impedance and output impedance as the amplifier stage (2).

16. Filter circuit according to one of claims 13 to 15, **characterized in that** the passive coupling elements (9) each have an attenuation of 3 dB.

## Revendications

1. Circuit de filtrage qui comprend un étage d'amplification (1), un filtre (2) placé en amont de l'étage d'amplification (1) avec au moins un piège (6) composé d'un circuit bouchon accordé à une fréquence intermédiaire et d'un circuit d'aspiration accordé à une fréquence-image, ainsi qu'un filtre passe-bande (3) accordé à la fréquence intermédiaire et placé en aval de l'étage d'amplification (1), **caractérisé en ce que** le circuit bouchon et le circuit d'aspiration présentent une inductance commune.

2. Circuit de filtrage conforme à la revendication 1, **caractérisé en ce que** l'un des circuits est constitué d'un tube coaxial λ/4 (4), où λ est la longueur d'onde correspondant à la fréquence intermédiaire.

3. Circuit de filtrage conforme à la revendication 1, **caractérisé en ce que** le tube coaxial λ/4 (4) est monté en parallèle à l'entrée de l'étage d'amplification (1) et est mis en court-circuit à son extrémité froide située sur le potentiel de référence.

4. Circuit de filtrage conforme à la revendication 2 ou 3, **caractérisé en ce que** le circuit d'aspiration est constitué d'un montage en série comprenant une capacité (5) et le tube coaxial λ/4 (4).

5. Circuit de filtrage conforme à la revendication 4, **caractérisé en ce que** la capacité (5) est placée entre l'entrée de l'étage d'amplification (1) et l'extrémité chaude du tube coaxial λ/4 (4).

6. Circuit de filtrage conforme à l'une des revendications 2 à 5, **caractérisé en ce que** le tube coaxial λ/4 (4) possède un diélectrique en matériau céramique.

7. Circuit de filtrage conforme à la revendication 6, **caractérisé en ce que** la constante diélectrique relative εᵣ du matériau céramique est d'environ 88.

8. Circuit de filtrage conforme à l'une des revendications 2 à 6, **caractérisé en ce que** l'impédance caractéristique Z₀ du tube coaxial λ/4 (4) est d'environ 2,5 Ohm.

9. Circuit de filtrage conforme à l'une des revendications 1 à 8, **caractérisé en ce que** les fréquences de résonance du circuit bouchon et du circuit d'aspiration sont situées dans la plage de 1 à 2 GHz, où la fréquence de résonance du circuit d'aspiration est de 78 MHz inférieure à celle du circuit du circuit bouchon.

10. Circuit de filtrage conforme à l'une des revendications 1 à 9, **caractérisé en ce que** les impédances d'entrée et de sortie de l'étage d'amplification (4) sont d'environ 50 Ohm.

11. Circuit de filtrage conforme à la revendication 6, **caractérisé en ce que** le filtre passe-bande (3) est un filtre en céramique à deux circuits accordé à la fréquence de résonance du circuit bouchon en tant que fréquence centrale.

12. Circuit de filtrage conforme à l'une des revendications 1 à 11, **caractérisé en ce que** le filtre (2) placé en amont est composé de plusieurs pièges en cascade (6, 7, 8).

13. Circuit de filtrage conforme à la revendication 12, **caractérisé en ce que** les pièges (6, 7, 8) sont couplés par des éléments de couplage passifs (9, 10).

14. Circuit de filtrage conforme à la revendication 13, **caractérisé en ce que** les éléments de couplage passifs(9, 10) sont conçus comme des atténuateurs en T et/ou des atténuateurs π.

15. Circuit de filtrage conforme à la revendication 13 ou 14, **caractérisé en ce que** les éléments de couplage passifs (9) présentent la même impédance d'entrée et de sortie que l'étage d'amplification (2).

16. Circuit de filtrage conforme à l'une des revendications 13 à 15, **caractérisé en ce que** les éléments de couplage passifs (9) présentent chacun une atténuation de 3 dB.
